# EUROPÄISCHE PATENTSCHRIFT

(11) **EP 3 430 653 B1**
(45) Veröffentlichungstag und Bekanntmachung des Hinweises auf die Patenterteilung: **28.12.2022**
(21) Anmeldenummer: 17707319.4
(22) Anmeldetag: 27.02.2017
(51) Int. Cl.: H01L 41/43, H01L 41/083

(54) **PIEZOELEKTRISCHES AKTUATORBAUELEMENT UND HERSTELLUNGSVERFAHREN ZUM HERSTELLEN EINES PIEZOELEKTRISCHEN AKTUATORBAUELEMENTES**
PIEZOELECTRIC ACTUATOR COMPONENT AND PRODUCTION METHOD FOR PRODUCING A PIEZOELECTRIC ACTUATOR COMPONENT
COMPOSANT ACTIONNEUR PIÉZOÉLECTRIQUE ET PROCÉDÉ DE FABRICATION D'UN COMPOSANT ACTIONNEUR PIÉZOÉLECTRIQUE

(30) Priorität: 16.03.2016 DE 102016204308
(43) Veröffentlichungstag der Anmeldung: 23.01.2019
(73) Patentinhaber: Vitesco Technologies GmbH, 93055 Regensburg (DE)
(72) Erfinder: ZUMSTRULL, Claus, 93128 Regenstauf (DE)
(74) Vertreter: Vitesco Technologies
(86) Internationale Anmeldenummer: PCT/EP2017/054454
(87) Internationale Veröffentlichungsnummer: WO 2017/157642

(56) Entgegenhaltungen:
- WO-A1-2013/017592
- DE-A1-102007 004 893
- DE-A1-102009 014 993

## Beschreibung

Die Erfindung betrifft ein piezoelektrisches Aktuatorbauelement sowie ein Herstellungsverfahren zum Herstellen eines solchen piezoelektrischen Aktuatorbauelementes.

Piezoelektrische Aktuatorbauelemente werden beispielsweise als elektronische Bauteile in Aktuatoreinheiten zum Einspritzen von Kraftstoff in einen Brennraum eines Zylinders einer Brennkraftmaschine verwendet.

Diese Aktuatorbauelemente weisen zumindest einen Schichtstapel aus einer Mehrzahl an piezoelektrischen Keramikschichten und einer Mehrzahl an Elektrodenschichten auf, die abwechselnd entlang einer Längsachse übereinander gestapelt sind, sodass zwischen zwei Keramikschichten jeweils eine Elektrodenschicht angeordnet ist und somit eine sogenannte Innenelektrode bildet. Diese Innenelektroden werden von außen elektrisch ankontaktiert, um eine Spannung anzulegen, sodass sich über den Piezoeffekt die Keramikschichten entlang der Längsachse ausdehnen und zusammenziehen können. Derartige piezoelektrische Aktuatorbauelemente werden besonders häufig als Piezoaktoren verwendet, um als Betätigungselemente in Einspritzventilen der verschiedensten Motortypen für Kraftfahrzeuge zur Anwendung zu kommen.

Die elektrische Kontaktierung der Elektrodenschichten als Innenelektroden solcher Aktuatorbauelemente wird mit zunehmenden Anforderungen an das Aktuatorbauelement wie beispielsweise höheren vorherrschenden Temperaturen, einer größeren Anzahl an Einspritzungen in kürzerer Zeit, höheren mechanischen Belastungen usw., thermisch, elektrisch und mechanisch immer stärker belastet. Dabei wirken diese erhöhten Anforderungen und Belastungen sowohl an einer Passivierungsschicht, die jede zweite Elektrodenschicht entlang der Längsachse elektrisch isoliert, als auch an stromführenden Ankontaktierungen jeder zweiten nicht elektrisch isolierten Elektrodenschicht.

Ein vollaktiver Piezostack mit Passivierung ist beispielsweise aus der WO 2013/017592 A1 bekannt. Die DE 10 2009 014 993 A1 offenbart eine elektrisch leitende Metallschicht zur Ankontaktierung in Kombination mit einer Passivierungsschicht, wobei die Metallschicht zunächst auf eine strukturierte Opferschicht aufgebracht wird, die anschließend wieder vollständig entfernt wird.

Ferner ist es bislang bekannt, solche Ankontaktierungen der Elektrodenschichten über einen Leitkleber zu realisieren. Leitkleber hat insgesamt eine geringe Stromtragfähigkeit und eine relativ schlechte Wärmeleitfähigkeit. Zudem besteht ein relativ hoher Übergangswiderstand zwischen dem verwendeten Leitkleber und den Elektrodenschichten.

Dadurch können Aktuatorbauelemente, bei denen die Elektrodenschichten über Leitkleber ankontaktiert werden, den zunehmenden Anforderungen und Belastungen immer schlechter standhalten.

Aus der DE 10 2007 004 893 A1 ist ein piezoelektrischer Vielschichtaktor bekannt mit einer Isolationsstruktur und einer gradierten Elektrode aus Leitkleber, die im Bereich der zu kontaktierenden Innenelektroden und dazwischen unterschiedliche Leitfähigkeiten und/oder mechanische Eigenschaften aufweist. Aus der WO2013017592 ist ein Piezostack bekannt, mit Seitenflächen , wobei an zwei sich gegenüberliegenden Seitenflächen über der jeweiligen Breite eine Passivierungsschicht aus Keramik angeordnet ist, an den anderen beiden sich gegenüberliegenden Seitenflächen jeweils eine Passivierungsschicht angeordnet ist, die Kunststoff umfasst, so dass alle Seitenflächen über die jeweilige Breite mit einer Passivierungsschicht versehen sind.

Aufgabe der Erfindung ist es daher, ein piezoelektrisches Aktuatorbauelement und ein entsprechendes Herstellungsverfahren vorzuschlagen, bei dem die oben genannten Nachteile überwunden werden können.

Diese Aufgabe wird mit einem piezoelektrischen Aktuatorbauelement mit den Merkmalen des unabhängigen Anspruches 1 gelöst.

Ein Herstellungsverfahren zum Herstellen eines solchen piezoelektrischen Aktuatorbauelementes ist Gegenstand des nebengeordneten Anspruches.

Vorteilhafte Ausgestaltungen der Erfindung sind Gegenstand der abhängigen Ansprüche.

Ein piezoelektrisches Aktuatorbauelement weist einen Schichtstapel aus piezoelektrischen Keramikschichten und Elektrodenschichten auf, die abwechselnd entlang einer Längsachse übereinandergestapelt sind, wobei der Schichtstapel mehrere sich parallel zu der Längsachse erstreckende Seitenflächen aufweist. Weiter ist eine Passivierungsschicht an wenigstens einer der Seitenflächen zum elektrischen Isolieren jeder zweiten entlang der Längsachse angeordneten Elektrodenschicht und eine Kontaktierungsschicht an der wenigstens einen Seitenfläche zum elektrischen Kontaktieren jeder zweiten, nicht durch die Passivierungsschicht elektrisch isolierten Elektrodenschicht vorgesehen, wobei die Passivierungsschicht an jeder der elektrisch isolierten Elektrodenschichten zumindest bereichsweise von der Kontaktierungsschicht bedeckt ist und wobei die Kontaktierungsschicht durch ein Sintersilber gebildet ist, und wobei die Passivierungsschicht durch ein Passivierungsschichtmaterial, insbesondere durch ein vollständig imidisiertes Polyimid gebildet ist, das bei der Sintertemperatur des Sintersilbers thermisch stabil ist.

Demgemäß wird vorgeschlagen, den bisher verwendeten Leitkleber durch ein gesintertes Silber zu ersetzen, das eine bessere Temperaturleitfähigkeit sowie eine bessere elektrische Leitfähigkeit aufweist als der Leitkleber, wodurch ein Übergangswiderstand zwischen der Kontaktierungsschicht und den Elektrodenschichten in dem Schichtstapel und ein Durchgangswiderstand durch die Kontaktierungsschicht verbessert wird. Dadurch, dass eine Passivierungsschicht verwendet wird, die auch bei der Sintertemperatur des Sintersilbers thermisch stabil ist, kann das piezoelektrische Aktuatorbauelement auch großtechnisch prozessiert werden.

In vorteilhafter Ausgestaltung ist die Passivierungsschicht durch ein Passivierungsschichtmaterial gebildet, das bis zu einer Temperatur von 350°C thermisch stabil ist.

Durch Verwendung von beispielsweise speziellen Additiven kann Silber schon bei Temperaturen unter 350° C gesintert und somit verarbeitet werden. Wird daher vorteilhaft beispielsweise ein Polyimid als Passivierungsschichtmaterial verwendet, das bei vollständiger Imidisierung auch bei 350° C thermisch noch stabil ist, ergibt sich so ein vorteilhaftes Temperaturfenster, bei dem das Passivierungsschichtmaterial und das Kontaktierungsschichtmaterial gemeinsam verarbeitet werden können.

Vorzugsweise ist der Schichtstapel als vollaktiver Schichtstapel ausgebildet, wobei sich alle entlang der Längsachse angeordneten Elektrodenschichten wenigstens an der wenigstens einen Seitenfläche im Wesentlichen bis zu einer Oberfläche des Schichtstapels erstrecken.

Vollaktive Schichtstapel haben große Vorteile hinsichtlich der Betätigung, Raumbeanspruchung und dem gesamten Betriebsverhalten eines piezoelektrischen Aktuatorbauelementes, da vorteilhaft eine gleichmäßigere Längsstreckung der Keramikschichten bei gleicher Raumbeanspruchung wie bei teilaktiven Schichtstapel erzielt werden kann.

In bevorzugter Ausgestaltung ist eine Oberfläche des Schichtstapels an der wenigstens einen Seitenfläche im Wesentlichen durch bündige Aneinanderreihung von an der wenigstens einen Seitenfläche angeordneten Stirnflächen der übereinandergestapelten Elektroden- und Keramikschichten ausgebildet, wobei die Oberfläche, insbesondere im Bereich der Passivierungsschicht, frei von sich in den Schichtstapel erstreckenden Gräben ausgebildet ist.

Vorteilhaft befindet sich so die Passivierungsschicht direkt an der Oberfläche des Schichtstapels, sodass keine Beeinträchtigung der vollaktiven Eigenschaften des Schichtstapels durch Grabenbildung im Bereich der Passivierungsschicht vorliegt, weil die volle Elektrodenfläche ausgenutzt werden kann.

Vorteilhaft ist die Passivierungsschicht als eine parallel zur Längsachse angeordnete Durchgangsschicht ausgebildet, die zum Freilegen der anzukontaktierenden Elektrodenschichten an jeder zweiten entlang der Längsachse angeordneten Elektrodenschicht einen, insbesondere durch Laserstrukturierung gebildeten, Kontaktierungsgraben aufweist. Alternativ kann die Passivierungsschicht auch aus an jeder zweiten entlang der Längsachse angeordneten Elektrodenschicht angeordneten Einzelpassivierungsschichten gebildet ist.

Durch Strukturierung der Passivierungsschicht kann so besonders einfach eine einzelne Schicht auf die Oberfläche des Schichtstapels an der wenigstens einen Seitenfläche aufgebracht werden, und dann einfach die anzukontaktierenden Elektrodenschichten beispielsweise durch eine Laserstrukturierung freigelegt werden. Dabei können die Elektrodenschichten so freigelegt werden, dass lediglich ein Teilbereich der anzukontaktierenden Elektrodenschicht freigelegt ist, und die Passivierungssicht weiterhin mit Ausnahme von derart gebildeten Kontaktierungsgräben eine durchgehende Durchgangsschicht bildet, es ist jedoch auch möglich, die Elektrodenschichten vollständig freizulegen, sodass sich Einzelpassivierungsschichten an jeder der Elektrodenschichten bilden, die elektrisch isoliert sein soll.

Bevorzugt sind die Elektrodenschichten mit Silber, insbesondere mit einer Silberlegierung, gebildet.

Werden vorteilhaft Elektrodenschichten als Innenelektroden verwendet, die mit oder aus Silber, z.B. einer Silberlegierung, gebildet sind, kann so eine sehr gute Verbindung zwischen dem Sintersilber der Kontaktierungsschicht und den Innenelektroden erreicht werden.

Ein Herstellungsverfahren zum Herstellen eines piezoelektrischen Aktuatorbauelementes weist die folgenden Schritte auf:
- Bereitstellen eines Schichtstapels aus piezoelektrischen Keramikschichten und Elektrodenschichten, die abwechselnd entlang einer Längsachse übereinandergestapelt sind, wobei der Schichtstapel mehrere sich parallel zu der Längsachse erstreckende Seitenflächen aufweist;
- Bilden einer elektrisch isolierenden Passivierungsschicht aus einem Passivierungsschichtmaterial an wenigstens einer der Seitenflächen, wobei das Passivierungsschichtmaterial ein Polyimid ist;
- Strukturieren, insbesondere Laserstrukturieren, der Passivierungsschicht zum Freilegen jeder zweiten entlang der Längsachse angeordneten Elektrodenschicht an der wenigstens einen Seitenfläche;
- Beschichten der strukturierten Passivierungsschicht mit einem Sintersilber;
- Sintern des Sintersilbers.

Vorzugsweise wird das Polyimid als Passivierungsschichtmaterial vor dem Beschichten der wenigstens einen Seitenfläche mit dem Sintersilber vollständig imidisiert.

In vorteilhafter Ausgestaltung wird als Schichtstapel ein vollaktiver Schichtstapel bereitgestellt, bei dem sich alle entlang der Längsachse angeordneten Elektrodenschichten wenigstens an der wenigstens einen Seitenfläche im Wesentlichen bis zu einer Oberfläche des Schichtstapels erstrecken.

Wird die strukturierte Passivierungsschicht so mit Sintersilber beschichtet, dass sie vollflächig mit dem Sintersilber bedeckt ist, ist es vorteilhaft, wenn sich die Passivierungsschicht vollständig über die Oberfläche der wenigstens einen Seitenfläche erstreckt, sodass vorteilhaft keine Überschläge im Betrieb des Aktuatorbauelementes vorkommen.

Vorteilhaft bildet das Sintersilber auf der Passivierungsschicht eine vollflächige Kontaktierungsschicht ohne Unterbrechungen und ohne Strukturierung, sodass dort vorteilhaft eine einfache Weiterkontaktierung zum Beispiel durch Anbringen einer Sammelelektrode möglich ist.

Eine vorteilhafte Ausgestaltung der Erfindung wird nachfolgend anhand der beigefügten Zeichnungen näher erläutert. Darin zeigt:
- Fig. 1: eine Längsschnittdarstellung eines piezoelektrischen Aktuatorbauelementes;
- Fig. 2: eine um 90° gedrehte Ansicht des Aktuatorbauelementes aus Fig. 1;
- Fig. 3: eine perspektivische Ansicht des Aktuatorbauelementes aus Fig. 1 und Fig. 2; und
- Fig. 4: ein schematisches Flussidagramm, das die Herstellungsschritte zum Herstellen des piezoelektrischen Aktuatorbauelementes aus den Fig. 1 bis Fig. 3 darstellt.

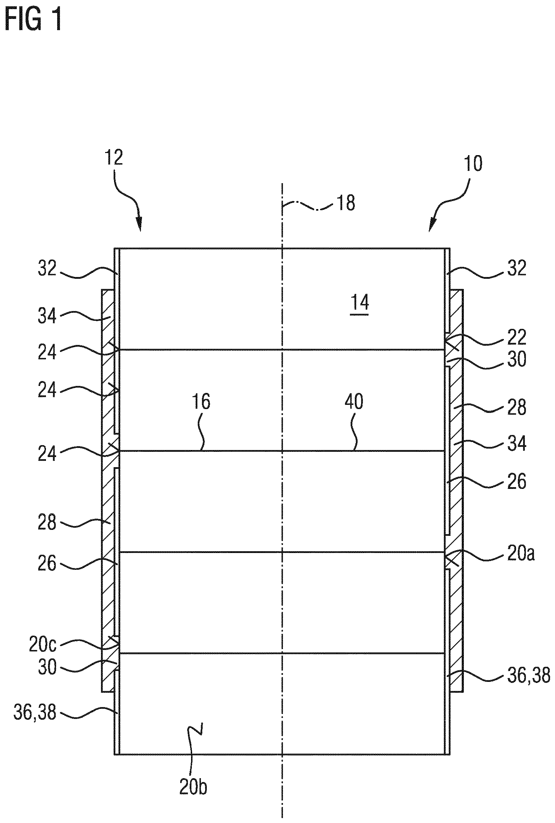

Fig. 1 zeigt eine Längsschnittdarstellung eines piezoelektrischen Aktuatorbauelementes 10, das einen Schichtstapel 12 aufweist, welcher aus piezoelektrischen Keramikschichten 14 und Elektrodenschichten 16 aufgebaut ist, die entlang einer Längsachse 18 abwechselnd aufeinandergestapelt sind, sodass jede Elektrodenschicht 16 zwischen zwei piezoelektrischen Keramikschichten 14 angeordnet ist.

Der Schichtstapel 12 weist mehrere Seitenflächen 20a - 20d auf, die sich parallel zu der Längsachse 18 erstrecken.

An zwei sich gegenüberliegenden Seitenflächen 20a, c ist eine Oberfläche 22 des Schichtstapels 12 dadurch gebildet, dass sich Stirnflächen 24 der übereinandergestapelten Elektroden- und Keramikschichten 14, 16 entlang der Längsachse 18 bündig aneinander reihen.

Insgesamt ist der Schichtstapel 12 als vollaktiver Schichtstapel 12 ausgebildet, das heißt, die Elektrodenschichten 16 bedecken senkrecht zu der Längsachse 18 vollflächig die jeweils benachbarten Keramikschichten 14 derart, dass sie sich an den Seitenflächen 20a - 20d des Schichtstapels 12 bis zu der Oberfläche 22 erstrecken, und somit aus dem Schichtstapel 12 hervortreten. Ein vollaktiver Schichtstapel 12 hat den Vorteil, dass bei kleinerer Raumbeanspruchung wenigstens ein gleiches Ausdehnungsverhalten wie oder sogar noch ein größeres Ausdehnungsverhalten kann als bei Schichtstapeln 12 erzielt werden, die nicht vollaktiv sind, das heißt, bei denen die Elektrodenschichten 16 abwechselnd von einer Oberfläche 22 des Schichtstapels 12 ausgehend in den Schichtstapel 12 hinein zurückversetzt angeordnet sind.

Um bei einer Ankontaktierung der Elektrodenschichten 16 von außen einen Überschlag zwischen benachbarten Elektrodenschichten 16, die unterschiedliche Potentiale aufweisen, zu vermeiden, ist an zwei sich gegenüberliegenden Seitenflächen 20a, c eine Passivierungsschicht 26 auf der Oberfläche 22 angeordnet, über die jede zweite entlang der Längsachse 18 angeordnete Elektrodenschicht 16 von außen elektrisch isoliert ist. Auf der Passivierungsschicht 26 ist zum elektrischen Kontaktieren der Elektrodenschichten 16 auf den beiden Seitenflächen 20a, c eine Kontaktierungsschicht 28 aufgebracht.

Damit diese Kontaktierungsschicht 28 die Elektrodenschichten 16 kontaktieren kann, die sie kontaktieren soll, sind in der Passivierungsschicht 26 Kontaktierungsgräben 30 eingebracht, beispielsweise durch Laserstrukturierung, sodass diese anzukontaktierenden Elektrodenschichten 16 freigelegt sind.

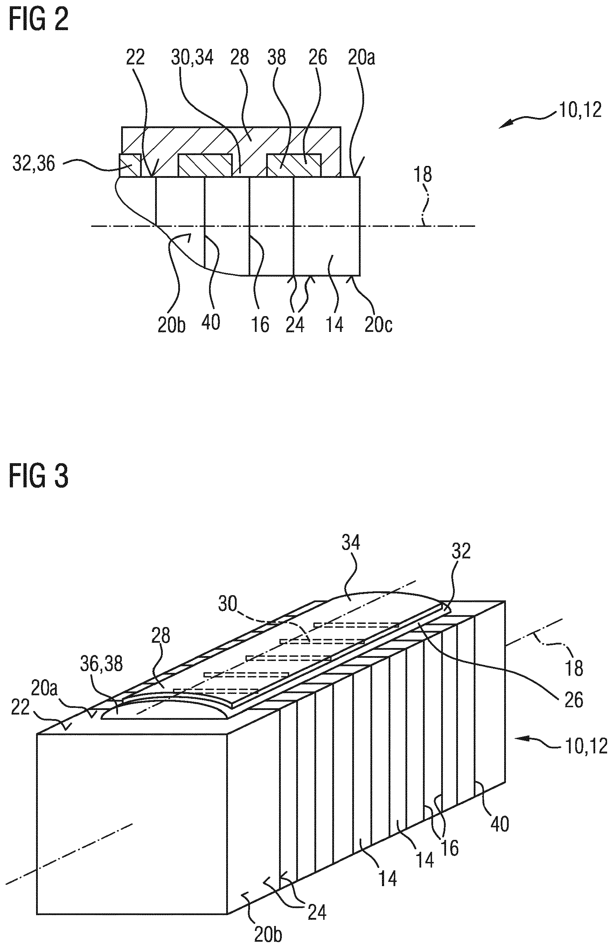

In den Längsschnittdarstellung in Fig. 1 und Fig. 2 sind diese Kontaktierungsgräben 30 von der Seite zu sehen, in Fig. 3 in einer perspektivischen Darstellung. Es ist möglich, dass die Kontaktierungsgräben 30, wie dies in der in Fig. 3 gezeigten Darstellung gezeigt ist, in einer als Durchgangsschicht 32 gebildeten Passivierungsschicht 26 einstrukturiert sind, es ist jedoch auch möglich, dass die Passivierungsschicht 26 nicht als durchgängige Durchgangsschicht 32 gebildet ist, sondern dass auf jeder zu isolierenden Elektrodenschichten 16 eine eigene Einzelpassivierungsschicht aufgebracht ist, die nicht mit den benachbarten Einzelpassivierungsschichten zusammenhängt.

Wie in Fig. 3 zu sehen ist, ist die Kontaktierungsschicht 28 genau in dem Bereich auf die Passivierungsschicht 26 aufgebracht, in dem die Kontaktierungsgräben 30 zum Freilegen der anzukontaktierenden Elektrodenschichten 16 angeordnet sind. Die Passivierungsschicht 26 ist daher zumindest bereichsweise von der Kontaktierungsschicht 28 bedeckt.

Wenn, wie in Fig. 3 gezeigt ist, die Passivierungsschicht 26 die senkrecht zu der Längsachse 18 an die Oberfläche 22 hervortretenden Elektrodenschichten 16 nicht vollflächig bedeckt, sondern bereichsweise freilässt, ist die Kontaktierungsschicht 28 vorteilhaft nur in dem Bereich der Kontaktierungsgräben 30 vorgesehen, um so einen Überschlag zwischen benachbarten Elektrodenschichten 16 zu vermeiden.

In die Kontaktierungsschicht 28 werden später Weiterkontaktierungen eingelegt, beispielsweise Kontaktierungspins, über die dann von außen eine Spannung an die jeweiligen kontaktierten Elektrodenschichten 16 angelegt werden kann. Um eine besonders stabile Ankontaktierung zu erreichen, die die zunehmenden Anforderungen an piezoelektrische Aktuatorbauelemente 10, wie sie beispielsweise in Injektoren von Brennkraftmaschinen verbaut sind, erfüllen, und bei denen hohe Temperaturen und hohe mechanische Belastungen vorliegen, ist die Kontaktierungsschicht 28 durch ein Sintersilber 34 gebildet. Sintersilber 34 hat den Vorteil, dass es eine sehr gute Temperaturleitfähigkeit und eine sehr gute elektrische Leitfähigkeit hat, wodurch ein Übergangswiderstand zu den Elektrodenschichten 16 und der Durchgangswiderstand durch die Kontaktierungsschicht 28 verbessert werden kann. Dadurch weist die Ankontaktierung der Elektrodenschichten 16 insgesamt eine gute thermische, elektrische und mechanische Widerstandskraft gegen hohe Belastungen auf.

Das Sintersilber 34 fließt in die Kontaktierungsgräben 30 und kommt so in direkten Kontakt mit den freigelegten Elektrodenschichten 16. Das Sintersilber 34 wird danach durch einen Sinterschritt verfestigt, sodass sich die stabile Kontaktierungsschicht 28 ausbildet. Das Sintern erfolgt dabei bei Temperaturen zumeist unter 350° C.

Da die Passivierungsschicht 26 bereits vor dem Sinterschritt des Sintersilbers 34 auf den Schichtstapel 12 aufgebracht ist, ist es wichtig, dass das Passivierungsschichtmaterial 36, aus dem die Passivierungsschicht 26 gebildet wird, bei der Sintertemperatur des Sintersilbers 34 thermisch stabil ist. Dazu wird vorteilhaft Polyimid 38 als Passivierungsschichtmaterial 36 verwendet, das bereits vor Aufbringen des Sintersilbers 34 vollständig imidisiert ist. Das bedeutet, die Polymerisationsreaktion aus einem Polyimid-Precursor, aus dem durch die Polymerisation das Polyimid 38 gebildet wird, hat schon zuvor stattgefunden. Ein solches vollständig imidisiertes Polyimid 38 ist vorteilhaft bis zu einer Temperatur von 350° C thermisch stabil und hat somit eine ausreichende thermische Widerstandskraft gegen die Sintertemperatur des Sintersilbers 34.

Es ist daher möglich, durch die vorteilhafte Kombination von Sintersilber 34 als Kontaktierungsschichtmaterial und Polyimid 38 als Passivierungsschichtmaterial 36 den Schichtstapel 12 schichtweise von innen nach außen aufzubauen.

Bei bisherigen Versuchen, Sintersilber 34 als vorteilhaftes Ankontaktierungsmaterial zu verwenden, bestand die Problematik, dass die bisher verwendeten Materialien zum Bilden der Passivierungsschicht 26 thermisch nicht stabil waren, sodass aufwendige Prozessschritte angewendet werden mussten, bei denen, zum Beispiel durch Bildung entsprechender Gräben, in dem Schichtstapel 12 eine aufgebrachte Sintersilberschicht mit dem Passivierungsschichtmaterial 36 unterschichtet werden musste, um zu verhindern, dass das Passivierungsschichtmaterial 36 der Sintertemperatur des Sintersilbers 34 ausgesetzt wird. Durch Vorsehen solcher Gräben gehen jedoch die vollaktiven Eigenschaften des Schichtstapels 12 verloren. Im Gegensatz dazu können diese vollaktiven Eigenschaften bei der Verwendung von Polyimid 38 als Passivierungsschichtmaterial 36 erhalten bleiben, da dieses nicht in extra gebildete Gräben das Sintersilber 34 unterschichten muss, weil das Sintersilber 34 nach Aufbringen des Polyimides 38 aufgesintert werden kann.

Um eine sehr gute Verbindung zwischen den Elektrodenschichten 16 und dem Sintersilber 34 als Kontaktierungsschicht 28 zu erzielen, ist es besonders vorteilhaft, wenn die Elektrodenschichten 16 mit bzw. aus einer Silberlegierung 40 gebildet sind.

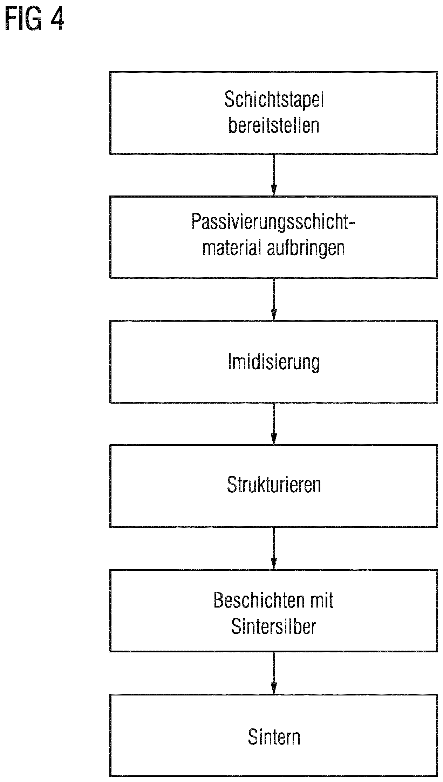

Fig. 4 zeigt eine schematische Darstellung eines Flussidagrammes eines Herstellungsverfahrens, mit dem das piezoelektrische Aktuatorbauelement 10 erzeugt wird. Dabei wird in einem ersten Schritt ein Schichtstapel 12 bereitgestellt, der entlang einer Längsachse 18 abwechselnd aufeinander geschichtete Keramikschichten 14 und Elektrodenschichten 16 aufweist. Dabei ist der Schichtstapel 12 insbesondere ein vollaktiver Schichtstapel 12, bei dem sich die Elektrodenschichten 16 bis an die Oberfläche 22 des Schichtstapels 12 erstrecken.

In einem zweiten Schritt wird dann auf wenigstens eine Seitenfläche 20 des Schichtstapels 12 das Passivierungsschichtmaterial 36 aufgebracht, beispielsweise ein Polyimid-Precursor, aus dem durch eine Polymerisationsreaktion ein Polyimid 38 gebildet werden kann. In einem dritten Schritt wird dann das Passivierungsschichtmaterial 36 ausgehärtet, beispielsweise bei der Verwendung von Polyimid 38 durch die vollständige Imidisierung. Dieser Schritt ist jedoch nur optional, es ist auch möglich, einen bereits voll imidisierten Lack zu verwenden, sodass der Imidisierungsschritt nicht zwingend erfolgen muss.

Danach wird die Passivierungsschicht 26 strukturiert, beispielsweise durch Laserstrukturieren, sodass jede zweite entlang der Längsachse 18 angeordnete Elektrodenschicht 16 freigelegt wird, damit sie von außen ankontaktiert werden kann. Danach wird in einem weiteren Schritt die so strukturierte Passivierungsschicht 26 mit einem Sintersilber 34 beschichtet, und zwar derart, dass das Sintersilber 34 in die strukturierten Kontaktierungsgräben 30 in der Passivierungsschicht 26 einläuft. Am Ende wird dann das Sintersilber 34 gesintert, um die Kontaktierungsschicht 28 auszuhärten und somit zu bilden.

## Patentansprüche

1. Piezoelektrisches Aktuatorbauelement (10), aufweisend:
- einen Schichtstapel (12) aus piezoelektrischen Keramikschichten (14) und Elektrodenschichten (16), die abwechselnd entlang einer Längsachse (18) übereinandergestapelt sind, wobei der Schichtstapel (12) mehrere sich parallel zu der Längsachse (18) erstreckende Seitenflächen (20a - d) aufweist;
- eine Passivierungsschicht (26) an wenigstens einer der Seitenflächen (20 a - d) zum elektrischen Isolieren jeder zweiten entlang der Längsachse (18) angeordneten Elektrodenschicht (16);
- eine Kontaktierungsschicht (28) an der wenigstens einen Seitenfläche (20 a - d) zum elektrischen Kontaktieren jeder zweiten, nicht durch die Passivierungsschicht (26) elektrisch isolierten Elektrodenschicht (16);
wobei die Passivierungsschicht (26) an jeder der elektrisch isolierten Elektrodenschichten (16) zumindest bereichsweise von der Kontaktierungsschicht (28) bedeckt ist,
- wobei die Kontaktierungsschicht (28) durch ein Sintersilber (34) gebildet ist und wobei die Passivierungsschicht (26) durch ein Passivierungsschichtmaterial (36), nämlich durch ein vollständig imidisiertes Polyimid (38) gebildet ist, das bei der Sintertemperatur des Sintersilbers (34) thermisch stabil ist.

2. Piezoelektrisches Aktuatorbauelement (10) nach Anspruch 1,
**dadurch gekennzeichnet, dass** die Passivierungsschicht (26) durch ein Passivierungsschichtmaterial (36) gebildet ist, das bis zu einer Temperatur von 350°C thermisch stabil ist.

3. Piezoelektrisches Aktuatorbauelement (10) nach einem der Ansprüche 1 oder 2,
**dadurch gekennzeichnet, dass** der Schichtstapel (12) als vollaktiver Schichtstapel (12) ausgebildet ist, wobei sich alle entlang der Längsachse (18) angeordneten Elektrodenschichten (16) wenigstens an der wenigstens einen Seitenfläche (20a - d) im Wesentlichen bis zu einer Oberfläche (22) des Schichtstapels (12) erstrecken.

4. Piezoelektrisches Aktuatorbauelement (10) nach einem der Ansprüche 1 bis 3,
**dadurch gekennzeichnet, dass** eine Oberfläche (22) des Schichtstapels (12) an der wenigstens einen Seitenfläche (20a - d) im Wesentlichen durch bündige Aneinanderreihung von an der wenigstens einen Seitenfläche (20a - d) angeordneten Stirnflächen (24) der übereinandergestapelten Elektroden- und Keramikschichten (16, 14) ausgebildet ist, wobei die Oberfläche (22), insbesondere im Bereich der Passivierungsschicht (26), frei von sich in den Schichtstapel (12) erstreckenden Gräben ausgebildet ist.

5. Piezoelektrisches Aktuatorbauelement (10) nach einem der Ansprüche 1 bis 4,
**dadurch gekennzeichnet, dass** die Passivierungsschicht (26) als eine parallel zur Längsachse (18) angeordnete Durchgangsschicht (32) ausgebildet ist, die zum Freilegen der anzukontaktierenden Elektrodenschichten (16) an jeder zweiten entlang der Längsachse (18) angeordneten Elektrodenschicht(16) einen, insbesondere durch Laserstrukturierung gebildeten, Kontaktierungsgraben (30) aufweist, oder dass die Passivierungsschicht (26) aus an jeder zweiten entlang der Längsachse (18) angeordneten Elektrodenschicht (16) angeordneten Einzelpassivierungsschichten gebildet ist.

6. Piezoelektrisches Aktuatorbauelement (10) nach einem der Ansprüche 1 bis 5,
**dadurch gekennzeichnet, dass** die Elektrodenschichten (16) mit Silber, insbesondere mit einer Silberlegierung (40), gebildet sind.

7. Herstellungsverfahren zum Herstellen eines piezoelektrischen Aktuatorbauelements (10), insbesondere nach einem der Ansprüche 1 bis 6, aufweisend die Schritte:
- Bereitstellen eines Schichtstapels (12) aus piezoelektrischen Keramikschichten (14) und Elektrodenschichten (16), die abwechselnd entlang einer Längsachse (18) übereinandergestapelt sind, wobei der Schichtstapel (12) mehrere sich parallel zu der Längsachse (18) erstreckende Seitenflächen (20 a-d) aufweist;
- Bilden einer elektrisch isolierenden Passivierungsschicht (26) aus einem Passivierungsschichtmaterial (36) an wenigstens einer der Seitenflächen (20 a-d), wobei als Passivierungsschichtmaterial (26) ein Polyimid (38) verwendet wird;
- Strukturieren, insbesondere Laserstrukturieren, der Passivierungsschicht (26) zum Freilegen jeder zweiten entlang der Längsachse (18) angeordneten Elektrodenschicht (16) an der wenigstens einen Seitenfläche (20 a-d);
- Beschichten der strukturierten Passivierungsschicht (26) mit einem Sintersilber (34);
- Sintern des Sintersilbers (34).

8. Herstellungsverfahren nach Anspruch 7,
wobei vor dem Beschichten der wenigstens einen Seitenfläche (20 a-d) mit dem Sintersilber (34) das Polyimid (38) insbesondere vollständig imidisiert wird.

9. Herstellungsverfahren nach einem der Ansprüche 7 oder 8,
**dadurch gekennzeichnet, dass** als Schichtstapel (12) ein vollaktiver Schichtstapel (12) bereitgestellt wird, bei dem sich alle entlang der Längsachse (18) angeordneten Elektrodenschichten (16) wenigstens an der wenigstens einen Seitenfläche (20 a-d) im Wesentlichen bis zu einer Oberfläche (22) des Schichtstapels (12) erstrecken.

## Claims

1. Piezoelectric actuator component (10), comprising:
- a layer stack (12) of piezoelectric ceramic layers (14) and electrode layers (16), which are stacked alternately one on top of the other along a longitudinal axis (18), the layer stack (12) having a number of side faces (20a - d) extending parallel to the longitudinal axis (18);
- a passivation layer (26) on at least one of the side faces (20a - d), for the electrical insulation of every second electrode layer (16) arranged along the longitudinal axis (18);
- a contacting layer (28) on the at least one side face (20a - d), for the electrical contacting of every second electrode layer (16) that is not electrically insulated by the passivation layer (26);
the passivation layer (26) on each of the electrically insulated electrode layers (16) being covered at least in certain regions by the contacting layer (28),
- the contacting layer (28) being formed by a sinter silver (34), and the passivation layer (26) being formed by a passivation layer material (36), to be specific by a completely imidized polyimide (38), which is thermally stable at the sintering temperature of the sinter silver (34).

2. Piezoelectric actuator component (10) according to Claim 1,
**characterized in that** the passivation layer (26) is formed by a passivation layer material (36) that is thermally stable up to a temperature of 350°C.

3. Piezoelectric actuator component (10) according to either of Claims 1 and 2,
**characterized in that** the layer stack (12) is formed as a fully active layer stack (12), all of the electrode layers (16) that are arranged along the longitudinal axis (18) extending essentially up to a surface (22) of the layer stack (12) at least on the at least one side face (20a - d) .

4. Piezoelectric actuator component (10) according to one of Claims 1 to 3,
**characterized in that** a surface (22) of the layer stack (12) on the at least one side face (20a - d) is formed essentially by arranging flush one against the other end faces (24) of the electrode layers (16) and ceramic layers (14) stacked one on top of the other that are arranged on the at least one side face (20a - d), the surface (22), in particular in the region of the passivation layer (26), being formed without any channels extending in the layer stack (12).

5. Piezoelectric actuator component (10) according to one of Claims 1 to 4,
**characterized in that** the passivation layer (26) is formed as a through-layer (32), which is arranged parallel to the longitudinal axis (18) and, for exposing the electrode layers (16) to be contacted, has at every second electrode layer (16) arranged along the longitudinal axis (18) a contacting channel (30), formed in particular by laser structuring, or **in that** the passivation layer (26) is formed by individual passivation layers arranged at every second electrode layer (16) arranged along the longitudinal axis (18).

6. Piezoelectric actuator component (10) according to one of Claims 1 to 5,
**characterized in that** the electrode layers (16) are formed with silver, in particular with a silver alloy (40) .

7. Production method for producing a piezoelectric actuator component (10), in particular according to one of Claims 1 to 6, comprising the steps of:
- providing a layer stack (12) of piezoelectric ceramic layers (14) and electrode layers (16), which are stacked alternately one on top of the other along a longitudinal axis (18), the layer stack (12) having a number of side faces (20a - d) extending parallel to the longitudinal axis (18);
- forming an electrically insulating passivation layer (26) from a passivation layer material (36) on at least one of the side faces (20a - d), a polyimide (38) being used as the passivation layer material (26);
- structuring, in particular laser structuring, the passivation layer (26) to expose every second electrode layer (16) arranged along the longitudinal axis (18) on the at least one side face (20a - d);
- coating the structured passivation layer (26) with a sinter silver (34);
- sintering the sinter silver (34).

8. Production method according to Claim 7,
the polyimide (38) being imidized, in particular completely, before the coating of the at least one side face (20a - d) with the sinter silver (34).

9. Production method according to either of Claims 7 and 8,
**characterized in that** a fully active layer stack (12), in which all of the electrode layers (16) that are arranged along the longitudinal axis (18) extend essentially up to a surface (22) of the layer stack (12) at least on the at least one side face (20a - d), is provided as the layer stack (12).

## Revendications

1. Composant formant actionneur piézoélectrique (10), ledit composant comportant :
- un empilement de couches (12) formé de couches de céramique piézoélectriques (14) et de couches d'électrodes (16) qui sont empilées alternativement les unes sur les autres le long d'un axe longitudinal (18), l'empilement de couches (12) comportant une pluralité de surfaces latérales (20a-d) qui s'étendent parallèlement à l'axe longitudinal (18) ;
- une couche de passivation (26) disposée sur au moins une des surfaces latérales (20a-d) et destinée à isoler électriquement une couche d'électrode (16) sur deux le long de l'axe longitudinal (18) ;
- une couche de contact (28) disposée sur l'au moins une surface latérale (20a-d) et destinée à venir en contact électrique avec une couche d'électrode (16) sur deux qui n'est pas isolée électriquement par la couche de passivation (26) ;
la couche de passivation (26) disposée sur chacune des couches d'électrode isolées électriquement (16) étant recouverte au moins partiellement par la couche de contact (28),
- la couche de contact (28) étant formée par un argent à fritter (34) et la couche de passivation (26) étant formée par un matériau de couche de passivation (36), à savoir par un polyimide entièrement imidisé (38), qui est thermiquement stable à la température de frittage de l'argent à fritter (34).

2. Composant formant actionneur piézoélectrique (10) selon la revendication 1,
**caractérisé en ce que** la couche de passivation (26) est formée par un matériau de couche de passivation (36) qui est thermiquement stable jusqu'à une température de 350 °C.

3. Composant formant actionneur piézoélectrique (10) selon l'une des revendications 1 ou 2,
**caractérisé en ce que** l'empilement de couches (12) est conçu comme un empilement de couches entièrement actif (12), toutes les couches d'électrodes (16) disposées le long de l'axe longitudinal (18) s'étendant au moins sur l'au moins une surface latérale (20a-d) sensiblement jusqu'à une surface supérieure (22) de l'empilement de couches (12).

4. Composant formant actionneur piézoélectrique (10) selon l'une des revendications 1 à 3,
**caractérisé en ce qu'**une surface supérieure (22) de l'empilement de couches (12) est sensiblement formée sur l'au moins une surface latérale (20a-d) par juxtaposition à fleur de surfaces frontales (24), disposées sur l'au moins une surface latérale (20a-d), des couches d'électrode et de céramique (16, 14) empilées les unes sur les autres, la surface supérieure (22) étant formée, en particulier dans la région de la couche de passivation (26), sans tranchées s'étendant dans l'empilement de couches (12).

5. Composant formant actionneur piézoélectrique (10) selon l'une des revendications 1 à 4,
**caractérisé en ce que** la couche de passivation (26) est conçue comme une couche traversante (32) qui est disposée parallèlement à l'axe longitudinal (18) et qui comporte, afin d'exposer les couches d'électrode (16) à contacter, des tranchées de contact (30), formées notamment par structuration laser, sur une couche d'électrode (16) sur deux disposée le long de l'axe longitudinal (18), ou **en ce que** la couche de passivation (26) est formée de couches de passivation individuelles disposées sur une couche d'électrode (16) sur deux disposée le long de l'axe longitudinal (18).

6. Composant formant actionneur piézoélectrique (10) selon l'une des revendications 1 à 5,
**caractérisé en ce que** les couches d'électrodes (16) sont formées avec de l'argent, en particulier avec un alliage d'argent (40).

7. Procédé de fabrication destiné à fabriquer un composant formant actionneur piézoélectrique (10), notamment selon l'une des revendications 1 à 6, ledit procédé de fabrication comprenant les étapes suivantes :
- fournir un empilement de couches (12) formé de couches de céramique piézoélectriques (14) et de couches d'électrodes (16) qui sont empilées alternativement les unes sur les autres le long d'un axe longitudinal (18), l'empilement de couches (12) comportant une pluralité de surfaces latérales (20 a-d) qui s'étendent parallèlement à l'axe longitudinal (18) ;
- former une couche de passivation électriquement isolante (26) à partir d'un matériau de couche de passivation (36) sur au moins une des surfaces latérales (20 a-d), un polyimide (38) étant utilisé comme matériau de couche de passivation (26) ;
- structurer, en particulier structurer au laser, la couche de passivation (26) pour exposer une couche d'électrode (16) sur deux, disposée le long de l'axe longitudinal (18), sur l'au moins une surface latérale (20 a-d) ;
- revêtir la couche de passivation structurée (26) avec un argent à fritter (34) ;
- fritter l'argent à fritter (34).

8. Procédé de fabrication selon la revendication 7,
le polyimide (38) étant en particulier complètement imidé avant que l'au moins une surface latérale (20 ad) ne soit revêtue d'argent à fritter (34).

9. Procédé de fabrication selon l'une des revendications 7 ou 8,
**caractérisé en ce que** l'empilement de couches (12) prévu est un empilement de couches entièrement actif (12) dans lequel toutes les couches d'électrode (16) disposées le long de l'axe longitudinal (18) s'étendent au moins sur l'au moins une surface latérale (20 a-d) sensiblement jusqu'à une surface supérieure (22) de l'empilement de couches (12).
